Europäisches Patentamt

European Patent Office

Office européen des brevets

(19)

(11) Publication number: **0 126 214**
**A2**

(12) ## EUROPEAN PATENT APPLICATION

(21) Application number: **84101445.9**

(22) Date of filing: **14.02.84**

(51) Int. Cl.³: **G 03 F 1/00**

(30) Priority: **16.05.83 US 495199**

(43) Date of publication of application: **28.11.84**
**Bulletin 84/48**

(84) Designated Contracting States: **DE FR GB**

(71) Applicant: **International Business Machines Corporation,
Old Orchard Road, Armonk, N.Y. 10504 (US)**

(72) Inventor: **Ito, Hiroshi, 7221 Via Colina, San Jose
California 95139 (US)**
Inventor: **Willson, Carlton Grant, 896 Harding Avenue,
San Jose California 95126 (US)**

(74) Representative: **Hobbs, Francis John, IBM United
Kingdom Patent Operations Hursley Park, Winchester,
Hants, SO21 2JN (GB)**

(54) **Process for making a lithographic mask.**

(57) In a self-development process for making a lithographic
mask, the radiation sensitive layer comprises capped polyphthalaldehyde and an onium salt sensitizer.

EP 0 126 214 A2

SA9-82-071                                   1

# PROCESS FOR MAKING A LITHOGRAPHIC MASK

This invention relates to a process for making a lithographic mask

US-A-3,915,704 discloses the use of sensitized polyphthalaldehyde as an electron beam resist, but the process disclosed therein does not yield self development.

Polymer Engr. and Sci., 14, 525 (1974) discloses a self development process, but the materials used in that process are very different from those used in a process in accordance with the present invention. As far as we are aware, no system prior to the present invention has provided clear, residue free relief images at $1\mu c/cm^2$ or even at higher dosage when cast in films greater than $2,000\overset{o}{A}$ thick.

The invention seeks to provide an improved self-development process.

Dev. Polym. Photochem., 1981, 2, 1, discloses the use of onium salts to catalyze polymerization. In the process according to the present invention, however, the onium salts are being used to catalyze depolymerization.

A process for making a lithographic mask comprising the steps of:

(1)   coating a transparent substrate with a thin opaque layer,

(2)   coating said opaque layer with a radiation sensitive layer,

(3)   imagewise exposing said sensitive layer to radiation and thereby removing the exposed portion thereof and uncovering a portion of the opaque layer, and

(4)   etching the uncovered portion of the opaque layer,

the process being characterized, according to the invention, in that the radiation sensitive layer comprises capped polyphthalaldehyde and an onium salt sensitizer.

How the invention can be carried out will now be described by way of example. A transparent substrate, e.g. glass or quartz, is first coated with a thin opaque layer e.g. chromium or iron oxide. The opaque layer is then coated with a layer of radiation sensitive material, and it is the composition of this radiation sensitive layer which is the - critical feature of the invention. The radiation sensitive layer comprises capped polyphthalaldehyde and a sensitizer which is an onium salt. Capped polyphthalaldehyde may be made as described in Macromolecules 2(4), 414 (1969). The radiation sensitive layer is imagewise exposed to radiation. The exposed portions of the layer are depolymerized, and the exposed portions of the layer are thereby removed, uncovering portions of the opaque layer beneath. It is an advantage of the present invention that this self-development, also called printout, takes place without the use of any solvent. It is also an advantage that the self-development is clean and residue-free, yielding sharp relief.

Capped polyphthalaldehyde, sensitized by the addition of an onium salt, can be exposed at dosages as low as 1 $\mu c/cm^2$ to provide clean relief images (self development) without further processing steps. The resulting images can be transferred into chromium on glass by any of a variety of etchants well known in the art, such as ceric ammonium nitrate etching. The advantages of this system over the state-of-the-art are that, (1) the material is the most sensitive positive resist known; (2) it develops upon exposure such that the linewidth is a function of dose only and not subject to error introduced in post expose cure, ashing or developing steps and (3) it provides the most efficient mask preparation sequence known, i.e., expose, etch and strip.

## Preferred Embodiment

Images were printed at $1\mu C/cm^2$ into $2.8\mu$ of polyphthalaldehyde resist containing 10% diphenylliodonium hexafluoroarsenate cast from cyclohexanone and prebaked at 90°C for 10 minutes. Such images were transferred into chromium (1000Å thick) on glass (standard borosilicate mask substrate) by exposing the imaged films to a solution of ceric ammonium nitrate (14%), nitric acid (4%), water (82%) for 45 seconds followed by a water rinse. The resist can also be imaged by exposure to 254 nm UV light at a dose of $2-6mJ/cm^2$ and can be dye sensitized to allow imaging at 313, 365 or 404 mm with similar sensitivity.

Following self development the exposed metal layer is etched, as in conventional processes.

The radiation may be electron beams, ultra-violet light, or even visible light when the system has been sensitized with a dye.

It is most preferred that the polyphthalaldehyde have a molecular weight of about Mn-50K, Mw/Mn≦2. The polyphthalaldehyde must be capped. Such capping is well known in the art, and may be done, for example, either by acetylation or alkylation.

In the present application, the expression onium salt is used in its conventional sense to mean salts which are organic compounds and isologs of ammonium chloride, and contain their central element, which may be N, O, S, Se,Sn or I in its highest positive valence. Useful onium salts include those formed from cations such as diphenyliodium, triphenylsulfonium, and thiophenoxydiphenylsulfonium, and anions such as hexafluoroarsenate, hexafluorophosphate and hexafluoroantimonate. In general, it is preferred that the onium salt sensitizer be present in the capped polyphthalaldehyde at a concentration of from about 5 to about 20 weight % of the solids.

## CLAIMS

1.  A process for making a lithographic mask comprising the steps of:
    (1) coating a transparent substrate with a thin opaque layer,
    (2) coating said opaque layer with a radiation sensitive layer,
    (3) imagewise exposing said sensitive layer to radiation and thereby removing the exposed portion thereof and uncovering a portion of the opaque layer, and
    (4) etching the uncovered portion of the opaque layer,

    the process being characterized in that the radiation sensitive layer comprises capped polyphthalaldehyde and an onium salt sensitizer.

2.  A process as claimed in Claim 1, wherein the onium salt is diphenyliodonium hexafluoroarsenate.

3.  A process as claimed in Claim 1, wherein the polyphthalaldehyde has a molecular weight of about MN-50K, with $Mw/Mn \leq 2$.

4.  A process as claimed in Claim 1, wherein the radiation is a beam of electrons.

5.  A process as claimed in Claim 1, wherein the radiation is visible light.

6.  A process as claimed in Claim 1, wherein the radiation is ultra-violet light.